Europäisches Patentamt

**European Patent Office**

**Office européen des brevets**

(11) Veröffentlichungsnummer: **0 301 296**

**A1**

## (12) EUROPÄISCHE PATENTANMELDUNG

(21) Anmeldenummer: **88110978.9**

(22) Anmeldetag: **08.07.88**

(51) Int. Cl.⁴: **H01J 37/16 , C23C 16/50**

(30) Priorität: **20.07.87 DE 8709952 U**

(43) Veröffentlichungstag der Anmeldung:
**01.02.89 Patentblatt 89/05**

(84) Benannte Vertragsstaaten:
**AT BE CH DE ES FR GB IT LI NL SE**

(71) Anmelder: **INTERATOM Gesellschaft mit
beschränkter Haftung
Friedrich-Ebert-Strasse
D-5060 Bergisch-Gladbach 1(DE)**

(72) Erfinder: **Nels, Albert
Otto-Braun-Strasse 17
D-5000 Köln 71(DE)**
Erfinder: **Cremer, Dieter
Immekeppeler Teich 8
D-5063 Overath 8(DE)**

(74) Vertreter: **Mehl, Ernst, Dipl.-Ing. et al
Postfach 22 13 17
D-8000 München 22(DE)**

(54) **Plasmabeschichtungskammer mit verkürzten Zykluszeiten und erleichterter Reinigung.**

(57) Die Zykluszeiten von Plasmabeschichtungskammern (1) werden verkürzt, indem für ihre Herstellung statt wie bislang üblich austenitische Stähle solche ferritischen Charakters verwendet werden, die günstigere magnetische und Wärmeleiteigenschaften aufweisen; Aufheiz- und Abkühlphasen eines Zyklus können so verkürzt werden. Wird die Kammer zumindest an ihrer Innenseite (4) vernickelt, so wird nicht nur der ferritische Stahl gegen Rost geschützt, sondern auch die Reinigung der Kammer erleichtert, da insbesondere das häufig verwendete Titannitrid auf Nickel schlecht haftet.

EP 0 301 296 A1

## Plasmabeschichtungskammer mit verkürzten Zykluszeiten und erleichterter Reinigung

Plasmabeschichtungskammern sind bekannt, z. B. aus der US-A-3 625 848. Mit ihrer Hilfe können Gegenstände der verschiedensten Art mit dünnen, gleichmäßigen und festhaftenden Überzügen versehen werden, wobei in letzter Zeit insbesondere Überzüge aus einem Hartstoff wie Titannitrid erhöhtes Interesse finden, weil durch die Beschichtung von spanenden Werkzeugen mit diesen Stoffen deren Verschleißfestigkeit sehr erhöht werden kann. In eine Kammer werden die zu beschichtenden Gegenstände eingebracht, diese evakuiert und ggf. anschließend bei niedrigem Druck mit einem Reaktionsgas gefüllt; anschließend wird zwischen einer verzehrbaren Kathode und einer Anode ein Lichtbogen gezündet, wodurch das Material der Kathode in den Plasmazustand überführt und ggf. nach Reaktion mit dem Gas auf den zu beschichtenden Gegenständen niedergeschlagen wird. Ein Teil des Niederschlages erfolgt dabei an eigentlich unerwünschter Stelle, nämlich der Kammerwandung und muß in regelmäßigen Abständen von dieser entfernt werden. Um den Prozeß in Gang zu bringen, müssen die Kammer und die zu beschichtenden Gegenstände eine gewisse Mindesttemperatur erreichen, wozu sie aufgeheizt werden müssen. Der laufende Prozeß seinerseits führt zu einer weiteren Wärmeentwicklung, sodaß nunmehr gekühlt werden muß, ebenso wie nach Ende des Prozesses, wenn die Zykluszeiten (die in der Größenordnung von 1 bis 2 Stunden liegen können) nicht durch "natürliches" Abkühlenlassen ungünstig verlängert werden sollen. Wegen ihrer guten mechanischen Eigenschaften und vor allem wegen ihrer Beständigkeit gegen eine große Anzahl von Chemikalien sind Plasmabeschichtungskammern bis jetzt vorzugsweise aus austenitischen Stählen hergestellt worden. Es hat sich jedoch gezeigt, daß die Qualität der in derartigen Kammern durchgeführten Beschichtungen wegen der ungünstigeren thermischen und elektromagnetischen Eigenschaften dieser Stähle höchsten Anforderungen nicht entspricht.

Aufgabe der vorliegenden Erfindung ist eine Verbesserung der Zykluszeiten von derartigen Plasmabeschichtungskammern dadurch, daß die zum Aufheizen bzw. Abkühlen der Kammer erforderlichen Zeitspannen verkürzt werden sowie der Qualität der in ihnen durchgeführten Beschichtungen. Ferner soll eine Erleichterung der Reinigung der Kammer von unerwünschtem Niederschlag auf ihren Innenwänden gewährleistet sein.

Die Lösung dieser Aufgabe erfolgt dadurch, daß für den Bau der Kammer ferritischer Stahl gewählt wird, der günstigere magnetische und Wärmeleiteigenschaften als austenitischer Stahl oder andere preislich und mechanisch für die Kammerfertigung in Frage kommende Werkstoffe aufweist. Der geringe Kostenvorteil des ferritischen Stahles tritt demgegenüber bei den allgemein hohen Kosten derartiger Anlagen zurück. Ferritische Stähle neigen bekanntlich stark zur Oxydation; es erscheint daher angebracht, eine daraus hergestellte Beschichtungskammer einem der vielen bekannten Oberflächenschutzverfahren zu unterziehen. Erfindungsgemäß wird hierfür eine Vernickelung vorgeschlagen, da diese nicht nur eine bewährte, dauerhafte Form des Rostschutzes darstellt, sondern auch wie sich gezeigt hat insbesondere Titannitrid auf ihrer Oberfläche nur sehr schlecht haftet. Der unerwünschte Niederschlag des Reaktionsproduktes kann unschwer mit werkstattüblichen Mitteln, z. B. einer Drahtbürste von den Wandungen der Kammer entfernt werden.

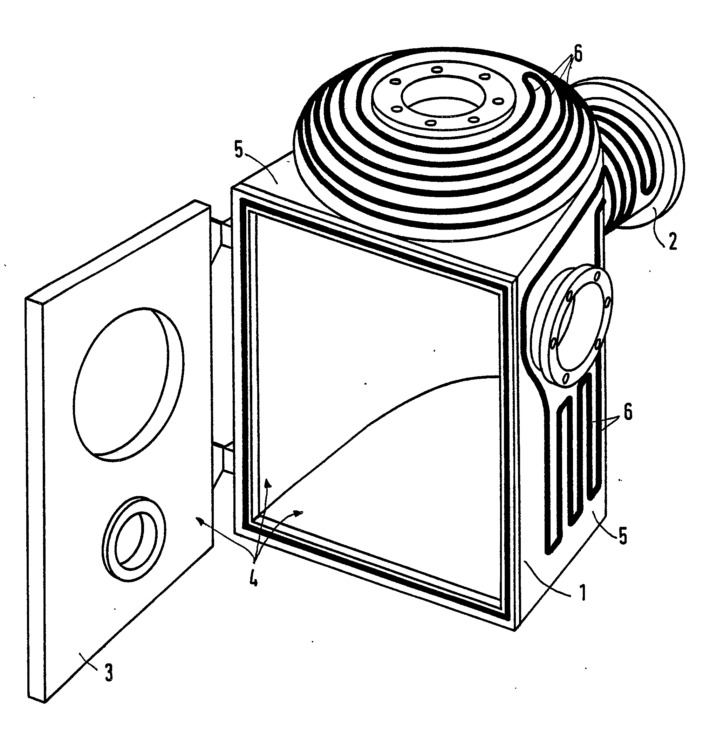

Ein Ausführungsbeispiel der Erfindung ist in der Zeichnung dargestellt, und zwar perspektivisch.

Eine aus ferritischem Stahl hergestellte Plasmabeschichtungskammer 1 (auf die Darstellung der erforderlichen Hilfsgeräte, z. B. einer an einen Stutzen 2 anzuschließenden Vakuumpumpe, wurde hier verzichtet) weist eine zur Be- und Entladung zu öffnende Tür 3 auf. Die gesamte Innenoberfläche 4 der Kammer ist vernickelt; ebenso alle Dichtflächen am Stutzen 2, der Tür 3 oder an nicht gesondert bezeichneten Zuleitungen für Prozeßgase usw. An ihrer Außenoberfläche 5 kann die Kammer auf andere Weise korrosionsgeschützt sein, z. B. mittels einer Lackierung. Durch auf der Kammer 1 angebrachte Rohrschlangen 6 kann je nach Bedarf ein Heiz- oder Kühlfluid zirkulieren.

### Ansprüche

1. Plasmabeschichtungskammer (1), **dadurch gekennzeichnet,** daß sie aus ferritischem Stahl hergestellt und mindestens an ihrer Innenoberfläche (4) vernickelt ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | JP-A-62 146 291 (SHOWA DENKO)(30-06-1987) & PATENT ABSTRACTS OF JAPAN, Band 11, Nr. 371 (C-462)[2818], 3. Dezember 1987, Seite 143 C 462; Zusammenfassung (Kat. P,Y) --- | 1 | H 01 J 37/16 C 23 C 16/50 |
| Y | US-A-4 526 644 (FUJIYAMA et al.) * Figur; Spalte 2, Zeile 30 - Spalte 4, Zeile 28 * ----- | 1 | |

**RECHERCHIERTE SACHGEBIETE (Int. Cl.4)**

H 01 J 37/00
H 01 J 5/00
C 23 C 16/00

Der vorliegende Recherchenbericht wurde für alle Patentansprüche erstellt

| Recherchenort | Abschlußdatum der Recherche | Prüfer |
|---|---|---|
| DEN HAAG | 17-10-1988 | SCHAUB G.G. |